# EUROPEAN PATENT APPLICATION

(11) **EP 1 047 194 A1**
(43) Date of publication of application: **25.10.2000**
(21) Application number: 99830239.2
(22) Date of filing: 23.04.1999
(51) Int. Cl.: H03K 19/013, H03K 5/24, H03F 3/30

(54) **High-frequency clipping stage**

(71) Applicant: STMicroelectronics S.r.l., 20041 Agrate Brianza (Milano) (IT)
(72) Inventor: Magazzu', Antonio, 98124 Messina (IT); Pelleriti, Roberto, 95100 Catania (IT); Marletta, Benedetto Marco, 95025 Aci Sant'Antonio (CT) (IT)
(74) Representative: Modiano, Guido, Dr.-Ing.

(57) **Abstract**

A clipping stage, particularly for high frequencies, which comprises:
a first power supply line (V_{CC}) and a second power supply line (V_{EE});
a differential input stage which is constituted by a first transistor (Q1) and a second transistor (Q2), is supplied by a first current source (Q4, R4) and is interposed between said first power supply line and said second power supply line;
a third transistor (Q3) which is connected between said first power supply line and said second power supply line and to said input stage and is supplied with power by a second current source (Q5, R5);
an output stage which is connected to said input stage and to an output load (R_{L}, C_{L});
the particularity of which consists of the fact that the stage further comprises an active load (Q8) which is arranged in parallel to said output load (R_{L}, C_{L}) and means (C) for driving said active load (Q8) which are suitable to drive the starting of a current pulse from said third transistor (Q3) to said active load (Q8), in order to provide a faster falling front of the output signal of said output stage.

## Description

The present invention relates to a clipping or squaring stage for high frequencies. More particularly, the invention relates to a high-frequency clipping stage with active pull-down.

It is known that in current electronic circuits there is the ever-growing need to provide stages with very fast output signal falling fronts due to the high operating speed of circuits arranged downstream of the stage being considered.

For example, in a frequency divider the phase information is linked to the transition instants of the output signal, which is synchronized with the input signal but is always influenced by delays or uncertainties in the transition instants which are obviously linked to the performance of the circuits that determine these events.

The delay and the uncertainties lead to phase errors which, since the downstream stages are synchronized on said output signal, propagate to the circuits that follow.

Accordingly, excessively slow output stages determine excessively slow fronts, that is to say, inaccurate zero crossing points.

If the operating frequency of the circuits is increased, a further problem accordingly arises which is again linked to the speed of the fronts of the output signal: the amplitude of the output signal. In other words, circuits that must operate at very high frequencies but do not have steep fronts can also provide output signals whose amplitude is low with respect to the amplitude required by the downstream circuits.

The above problems accordingly lead to the design of stages which have very steep synchronization fronts, such as to minimize phase noise and at the same time provide a signal whose amplitude is sufficient to drive the successive stages.

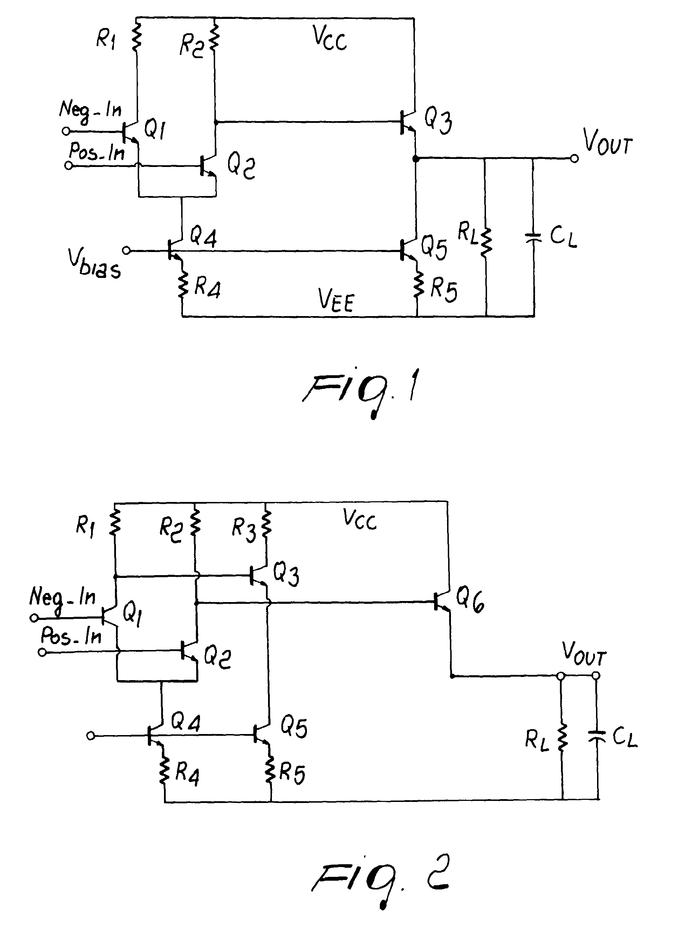

An example of a stage which is suitable to provide a faster falling front of the output signal is shown in figure 1, wherein the stage uses an active load in order to provide a faster falling front of the output signal which acts uniformly on the entire period of the signal. First of all, this stage has a fixed and high current consumption, caused by the source Q5-R5, and has phase noise problems due to the capacitive coupling that occurs between the output nodes and the base of transistor Q5. When the pull-up is powered on, this causes an increase in the current in the transistor Q5 and accordingly slows the rising front.

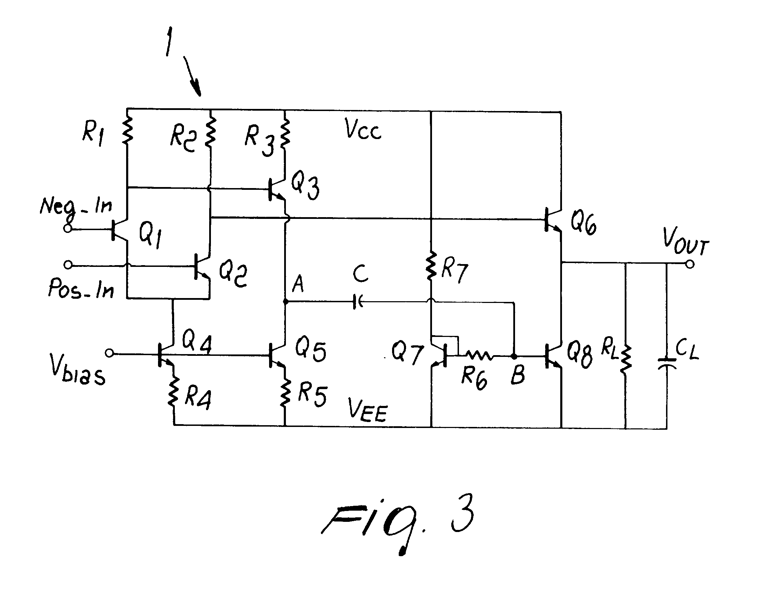

A solution which is similar to the preceding one but allows to eliminate most of the phase noise, avoiding the use of an active pull-down, is shown in figure 2, in which identical reference numerals designate identical elements.

In said stage, the output is directly of the open-emitter type (emitter of the transistor Q6), closing the circuit on an external resistor R_{L} and on the capacitive load C_{L} provided by the components arranged downstream of the stage being considered. In this case, however, the falling time of the output signal is longer than in the preceding case and the peak-to-peak amplitude of the output signal also decreases as one moves toward higher frequency values.

This, as mentioned, is a drawback which must absolutely be avoided, since a reduced amplitude of the output signal may not meet the requirements of the circuits located downstream of the stage.

The aim of the present invention is to provide a high-frequency clipping stage which allows to provide a faster falling front of the output signal.

Within the scope of this aim, an object of the present invention is to provide a high-frequency clipping stage which provides a faster falling front of the output signal by acting in a precise time interval of the front.

Another object of the present invention is to provide a high-frequency clipping stage which is suitable to reduce the falling time of the output signal of the frequency divider.

Another object of the present invention is to provide a high-frequency clipping stage which allows to provide a faster falling time of the output signal of a circuit that precedes the stage without increasing phase noise and without decreasing the amplitude of said signal.

Another object of the present invention is to provide a high-frequency clipping stage which allows to avoid excessively influencing the zero crossing instant of the output signal.

Another object of the present invention is to provide a high-frequency clipping stage which is highly reliable, relatively easy to produce and at competitive costs.

This aim, these objects and others which will become apparent hereinafter are achieved by a clipping stage, particularly for high frequencies, which comprises:
a first power supply line and a second power supply line;
a differential input stage which is constituted by a first transistor and a second transistor, is supplied by a first current source and is interposed between said first power supply line and said second power supply line;
a third transistor which is connected between said first power supply line and said second power supply line and to said input stage and is supplied with power by a second current source;
an output stage which is connected to said input stage and to an output load;
characterized in that it further comprises an active load which is arranged in parallel to said output load and means for driving said active load which are suitable to drive the starting of a current pulse from said third transistor to said active load, in order to provide a faster falling front of the output signal of said output stage.

Further characteristics and advantages of the invention will become apparent from the description of a preferred but not exclusive embodiment of the clipping stage according to the invention, illustrated only by way of non-limitative example in the accompanying drawings, wherein:
Figure 1 is a circuit diagram of a conventional clipping stage;
Figure 2 is a circuit diagram of another conventional clipping stage; and
Figure 3 is a view of the clipping stage according to the present invention.

With reference therefore to figure 3, in which the same reference numerals as in figures 1 and 2 have been used to designate corresponding elements, the clipping stage according to the invention, generally designated by the reference numeral 1, comprises a first transistor Q1 and a second transistor Q2, the base terminals of which are fed with signals Neg-in and Pos-in respectively, said signals arriving from a circuit located upstream with respect to the stage; resistors R1 and R2 are respectively connected to the collector terminals of said first and second transistors and their terminals that lie opposite with respect to those for connection to the collectors of the transistors Q1 and Q2 are connected to the supply voltage Vcc.

A third transistor Q3 is connected to the collector terminal of the first transistor Q1 and to a third resistor R3 which is connected to its collector terminal and to the supply voltage Vcc.

A fourth transistor Q4 is connected, by means of its collector terminal, to the emitter terminals of the transistors Q1 and Q2, and a fourth resistor R4 is connected to the emitter terminal of the transistor Q4.

A bias voltage Vbias is fed to the base terminal of the transistor Q4 and to the base terminal of a fifth transistor Q5, which is connected, by means of its collector terminal, to the emitter terminal of the third transistor Q3 and, by means of its emitter terminal, to a fifth resistor R5 which is common-connected, by means of its opposite terminal, to the terminal of the resistor R4.

A sixth transistor Q6 is connected, by means of its base terminal, to the collector terminal of the second transistor Q2 and by means of its collector terminal to the supply voltage Vcc.

The emitter terminal of the transistor Q6 is connected to the output node and the output of the circuit according to the invention has a load resistor R_{L} which is in parallel with respect to a capacitor C_{L}, in a manner similar to the one shown in the known circuits of figures 1 and 2.

The particularity of the invention is the fact that there is a seventh transistor Q7 which is diode-connected and is connected, by means of its emitter terminal, to the second power supply line Vₑₑ, to which the resistors R4, R5 and R_{L} and the capacitor C_{L} are also connected.

The seventh resistor Q7 has a current source 17 which is connected to its collector terminal and to the supply voltage Vcc and a sixth resistor R6 which is connected to the base terminal of an eighth transistor Q8 which is in turn connected between the second power supply line V_{EE} and the emitter terminal of the sixth transistor Q6.

The eighth transistor Q8 is therefore parallel-connected to the resistor R_{L} and to the capacitor C_{L}. Finally, a capacitor C is fedback between a node B taken between the base terminal of the transistor Q8 and the resistor R6 and a node A located between the emitter terminal of the transistor Q3 and the collector terminal of the transistor Q5.

As explained, the stage has a differentiated input provided by the transistors Q1 and Q2, and _{Vbias} is the bias voltage of the current sources Q4-R4 and Q5-R5.

With reference therefore to figure 3, the operation of the circuit according to the invention is as follows.

The output signal (voltage) Vₒᵤₜ starts to decrease as soon as the input signal Pos-in increases and therefore the signal Neg-in decreases. At the same time, the voltage across the base terminal of the transistor Q3 starts to increase, followed by its emitter current. This occurs instantaneously by virtue of the current source Q5-R5, whose values are chosen so that when the output voltage and therefore the signal Neg-in become high, it fully discharges the capacitor C and switches back on the transistor Q3 before the signal Neg-in becomes low again.

The resistor R3 limits the current that flows into the transistor Q3 and therefore into the capacitor C. In this manner it is possible to precisely select the amount of charge supplied to the base terminal of the transistor Q8.

The voltage across the capacitor C in fact cannot vary instantaneously and therefore the voltage of the node B of the capacitor C increases simultaneously with the voltage in the node A and therefore a current pulse from the emitter terminal of the transistor Q3 is transmitted, across the capacitor C, to the base terminal of the transistor Q8. Said current is amplified by the current gain of the transistor Q8 between the base and the collector. The transistor Q8 constitutes an active load which is accordingly controlled by the capacitor C.

When the current pulse supplied by the transistor Q3 reaches the transistor Q8, the collector current of the transistor Q8 has a short but high-amplitude current pulse, so as to provide a faster fall time for the voltage at the node V_{OUT} while acting only on the initial base thereof.

The instantaneous charge variation on the capacitor C is in fact rapidly extinguished across the base terminal of the transistor Q8 and the operating condition of the entire circuit is restabilized.

The current source formed by the transistor Q7 is inserted in order to pre-bias the transistor Q8. Said source in fact acts by applying to the transistor Q8 a voltage between the base and the emitter which keeps it at the limit between the off region and the linear region.

In practice, the collector current of the transistor Q8 is small during the normal operation of the circuit and the current peak at its base terminal is than able to bring said transistor well into the linear operating region. In this manner, the contribution provided by the phase error during the rising front of the voltage V_{OUT} is limited by virtue of the low current intensity involved.

The resistor R6 limits the current that enters the base terminal of the transistor Q7 and thus partly limits the charge injected by the capacitor C into the current source (Q7) during the discharge of the node V_{OUT}.

The transistors Q7 and Q8 are therefore arranged in a current-mirror configuration, with a mirroring factor of preferably less than 1, so as to limit the current of the transistor Q8 outside the operating region of interest.

Therefore, the circuit according to the invention allows to limit the duration of the pulse to a short time interval of the falling front of the signal V_{OUT}. The current consumption of the active load (transistor Q8) is reduced outside said time interval and there is no reduction in the amplitude of the output signal as the frequency increases.

In practice it has been found that the clipping stage according to the invention fully achieves the intended aim, since it allows to provide a faster falling time of the output voltage of a circuit arranged upstream of the stage without increasing phase noise, which is the fundamental drawback that occurs in known circuit solutions.

Furthermore, the clipping stage according to the invention has the advantage of not varying (reducing) the amplitude of the output signal V_{OUT}, making the falling front of said signal faster only in a portion of the entire front, without negatively altering the zero crossing instant of said signal during the rising front thereof.

The clipping stage thus conceived is susceptible of numerous modifications and variations, all of which are within the scope of the inventive concept; all the details may furthermore be replaced with other technically equivalent elements.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A clipping stage, particularly for high frequencies, which comprises:
a first power supply line and a second power supply line;
a differential input stage which is constituted by a first transistor and a second transistor, is supplied by a first current source and is interposed between said first power supply line and said second power supply line;
a third transistor which is connected between said first power supply line and said second power supply line and to said input stage and is supplied with power by a second current source;
an output stage which is connected to said input stage and to an output load;
characterized in that it further comprises an active load which is arranged in parallel to said output load and means for driving said active load which are suitable to drive the starting of a current pulse from said third transistor to said active load, in order to provide a faster falling front of the output signal of said output stage.

2. The clipping stage according to claim 1, characterized in that said active load comprises a transistor in which the base terminal is connected to the emitter terminal of said third transistor, the emitter terminal is connected to said second power supply line, and the collector terminal is connected to said output stage.

3. The clipping stage according to claim 2, characterized in that said means for driving the active load comprise a capacitor which is connected between the base terminal of said transistor that constitutes said active load and a node between the emitter terminal of said third transistor and said second current source.

4. The clipping stage according to claim 2, characterized in that it comprises means for limiting the current of said transistor that constitutes the active load, said means being arranged between said first and second power supply lines and being connected to the base terminal of said transistor that constitutes the active load.

5. The clipping stage according to claim 4, characterized in that said current limiting means comprise a transistor which is diode-connected and whose base terminal is connected, with a resistor interposed, to the base terminal of said transistor that constitutes said active load.

6. The clipping stage according to claim 5, characterized in that said diode-connected transistor forms a current mirror with said transistor that constitutes said active load.

7. The clipping stage according to claim 1, characterized in that said output stage comprises a transistor in which the base terminal is connected to said input stage, the collector terminal is connected to said first power supply line and the emitter terminal is connected to said active load.

8. The clipping stage according to claim 7, characterized in that said transistor of the output stage is connected, by means of its base terminal, to the collector terminal of said second transistor of said input stage.

9. The clipping stage according to claim 1, characterized in that said third transistor is connected, by means of its base terminal, to the collector terminal of said first transistor of the input stage.

10. The clipping stage according to claim 5, characterized in that said diode-connected transistor is connected to said first power supply line by means of a current source.

11. The clipping stage according to claim 1, characterized in that said third transistor is connected to said first power supply line by means of a resistor, the emitter terminal of said third transistor being connected to said second current source.

12. The clipping stage according to claim 1, characterized in that said first and second transistors of the input stage receive a differential input signal at the respective base terminals.
